# EUROPEAN PATENT APPLICATION

(11) **EP 2 634 295 A1**
(43) Date of publication of application: **04.09.2013**
(21) Application number: 11836702.8
(22) Date of filing: 18.08.2011
(51) Int. Cl.: C30B 33/00, C30B 29/36, C01B 31/36, A44C 17/00

(54) **METHOD FOR PRODUCING GEMSTONES FROM SILICON CARBIDE**

(30) Priority: 28.10.2010 RU 2010144123
(71) Applicant: Obshestvo S Ogranichennoj Otvetstvennostju "Grannik", Moscow 127051 (RU)
(72) Inventor: KLISHIN, Aleksandr Valerevich, Moscow 121614 (RU); PETROV, Jurij Ivanovich, Dzerzhinskij Moskovskaya obl. 140093 (RU); TUZLUKOV, Viktor Anatol'evich, Vladivostok 690080 (RU)
(74) Representative: Engel, Christoph Klaus
(86) International application number: PCT/RU2011/000627
(87) International publication number: WO 2012/057651

(57) **Abstract**

The invention relates to growing and processing monocrystals. Silicon carbide produced by the method of the present invention can be used not only for the electronic industry and jewelry-making but also as glass for watches or watchcase. The method comprises simultaneously growing a plurality of moissanite crystal blanks in a honeycomb mold of molding graphite, separating the blanks into individual crystals, faceting, grinding and polishing the crystals. Prior to faceting, the blanks are glued onto a mandrel with their one side and then-with the reverse side thereof. Polishing is carried out on a ceramic wheel rotating at a rate of 200 to 300 rpm using diamond powder spray with a grain size of 0.125-0.45 µm to ensure that the depth of scratch marks be less than the length of a light wave in the visible part of the spectrum, and the cut and cleaved edges and defective blanks unsuitable for faceting are pulverized and returned to the stage of growing.

## Description

The invention relates to growing and processing monocrystals.

Silicon carbide (SiC) produced by the method of the present invention can be used not only for the electronic industry and jewelry-making but also as glass for watches, mobile telephones, eyewear, players and other accessories.

SiC (carborundum) is a binary inorganic compound of silicon and carbon. It occurs in nature in a very rare mineral called moissanite. Powdered SiC was first obtained in 1893. It is used in abrasives, semiconductors, synthetic precious stones. It is mostly used in abrasives but lately this material has been also used in semiconductors and for imitation of gem-quality diamonds.

When used in jewelry as a gem, SiC is called "synthetic moissanite" or simply "moissanite". Moissanite is similar to diamond in that it is clear and hard (9-9.5 Mohs of hardness compared to 10 in diamond) and has a refraction index of 2.65-2.69 (compared to 2.42 in diamond). Moissanite has a somewhat more complicated structure than common cubic zirconium. In contrast to diamond, moissanite has a high birefringence. This feature may be desirable in some optic structures rather than in precious stones. For this reason, when manufacturing gems, the crystal is cut along the optic axis in order to minimize the birefringence effect. Moissanite has a lower density of 3.21 g/cm³ (versus 3.53 g/cm³ in diamond) and is far more thermally resistant. As a result, a gem is obtained with a strong brilliance, distinct faces and high environmental resistance. Unlike diamond which starts to burn at a temperature of 800°C, moissanite remains intact at temperatures up to 1800°C (for comparison, 1064°C is a melting temperature of pure gold). Moissanite has become popular as a diamond substitute and may be mistakenly taken for diamond since its thermal conductivity is far closer to that of diamond than in any other diamond substitute. Faceted moissanite may be distinguished from diamond judging by its birefringence and a very low-level of green or yellow fluorescence in the ultraviolet light (O'Donoghue, M. Gems. Elsevier, 2006, page 89; ISBN 0-75-065856-8) .

Known in the art are the methods for producing SiC, for example, in a polycrystalline form (RU 2327248 C30B 33/00, 2005) as well as in the form of monocrystals (RU 2156330 C30B 33/00, 2000).

The method according to the invention differs from all prior art methods in simultaneously growing a plurality of monocrystals in a graphite mold whereby the technical effect consisting in an improve quality of crystals is achieved. In addition, productivity increases since blanks are immediately obtained from cultivation so that the cutting operation is avoided, i.e., production costs and cutting-induced material losses are reduced.

The above effect is achieved by means of providing a method of simultaneous production of a plurality of precious stones from synthetic silicon carbide, i.e., moissanite, the method comprising growing simultaneously a plurality of moissanite crystal blanks in a honeycomb mold of molding graphite, separating the blanks into individual crystals, and faceting comprising three stages: rough cutting, grinding and polishing the crystals, wherein prior to faceting, the blanks are glued onto a mandrel with their one side and then--with the reverse side thereof, and polishing moissanite is carried out on a ceramic wheel rotating at a rate of 200 to 300 rpm using diamond powder spray with a grain size of 0.125-0.45 pm to ensure that the depth of scratch marks be less than the length of a light wave in the visible part of the spectrum, and wherein the cut and cleaved edges and defective blanks unsuitable for faceting are pulverized and returned to the stage of growing.

Preferably, a grinding paste with a grain size of 0.25 µm is used for grinding.

According to the invention, the method of the simultaneous production of precious stones from synthetic silicon carbidemoissanite is carried out as follows: a plurality of moissanite crystal blanks is simultaneously grown in a honeycomb mold of molding graphite. Separating the blanks into individual crystals, faceting, grinding and polishing the same is carried out as follows: each blank is glued onto a metal mandrel, it upper side is processed and then the blank is re-glued with the processed side thereof onto another mandrel, and the operations of faceting, grinding and polishing are repeated on the remaining side. Polishing the blanks is carried out on a ceramic wheel rotating at a rate of 200 to 300 rpm using diamond powder spray with a grain size of 0.125-0.45 µm to ensure that the depth of scratch marks be less than the length of a light wave in the visible part of the spectrum. The cut and cleaved edges and defective blanks unsuitable for faceting are pulverized and returned to the stage of growing. Preferably, a diamond grinding paste with a grain size of 5 to 10 µm is used for grinding.

The method is further illustrated by the following examples.

### EXAMPLE 1

A plurality of moissanite crystal blanks was simultaneously grown in a honeycomb mold of molding graphite. The grown crystals were separated into individual blanks. Faceting was carried out comprising three stages: rough cutting, grinding and polishing, the blanks being in advance glued onto a special mandrel and then, the blanks were re-glued onto the reverse side thereof, and processed similarly. The operation of polishing moissanite was carried out on a steel wheel rotating at a rate of 200 rpm using a grinding paste with a grain size of 0.25 µm, the cut and cleaved edges and defective blanks unsuitable for faceting being pulverized and returned to the stage of growing.

### EXAMPLE 2

A plurality of moissanite crystal blanks was simultaneously grown in a honeycomb mold of molding graphite. The grown crystals were separated into individual blanks. Prior to faceting, blanks were glued onto a substrate, and then with the reverse side thereof and faceted again. Those moissanite blanks were polished on a steel wheel rotating at a rate of 280 rpm using a grinding paste with a grain size of 0.45 µm, the cut and cleaved edges and defective blanks unsuitable for faceting being pulverized and returned to the stage of growing.

### EXAMPLE 3

All stages were performed as those in Example 2, except for using the grinding paste with the grain size of 0.25 µm.

The resulting monocrystals are suitable for use in jewelry-making.

It should be noted that faceting of diamond and moissanite differs in that diamond becomes very hot during faceting and for that reason it is mechanically gripped in the collet of the faceting head, while moissanite is simply glued to a metal mandrel using a hot-melt glue.

Diamonds are cut on the heavy cast-iron wheel at a rate of 3000 rpm and more, wherein both cutting and polishing are performed on the same wheel. In contrast, faceting moissanite comprises three stages: rough cutting, grinding and polishing which are performed on different wheels at a far lower rotation rate.

The production of faceted jewelry inserts by the present method comprises a number of stages. If needed, an obtained sample of silicon carbide is subject to coarse finishing (rough cutting). This stage is carried out on abrasive wheels with the grain size of 20 to 100 µm depending on the blank size and the quantity of materials to be ground down. Rough cutting results in obtaining to-be-faceted inserts of the appropriate shape.

In order to bring the insert faces to each other more precisely, an optional intermediate processing may be then performed on grinding or cutting wheels with the abrasive grain size of 3-10 µm. A finer grinding, i.e., polishing the faces of the faceted inserts, according to the present method is accomplished using fine grained abrasives with the grain size of 0.125-0.5 to avoid forming multiple scratches, whose depth is commensurate with the length of a light wave in the visible part of the spectrum. In this, there lies one more difference from the prior art where an abrasive with the grain size of 0.5-3 µm is used for polishing. The rotation rate of the polishing wheel should not be high (about 200-300 rpm) and the pressing force of the insert to the wheel surface should be low to avoid rounding of edges and surface warp of faces.

The above stages are performed for all faces on one side of the insert (top or bottom) and then repeated for the opposite side.

It is a common faceting practice to use for polishing the abrasive powder (spray, paste, emulsion, etc.) comprising grains of diamond, metal oxides or other hard materials with the grain size of 0.5 µm or more. However, the grains of such size may leave multiple scratches commensurate in depth so that the light flux will partially scatter. To the contrary, faceted inserts produced by the present method are polished with abrasive powders with the grain size of 0.125-0.25 µm so that, subject to adherence to polishing technique, the required surface finish (corresponding to the 11th grade of finish according to GOST 2789-59) is enabled, and scattering of the light flux is avoided. In this case, depending on the angle of incidence, the light incident on the facet surface either reflects or penetrates whereby it is refracted and contributes to the internal reflection facilitating the stellar shining effect to occur. In other words, if the depth of the scratches is less than the length of a light wave in the visible part of the spectrum (0.4 µm), these scratches have no pronounced effect on the path of incident rays. If the scratches become deeper, the light flux hitting the same slightly scatters so that the color flashing (change of color, shine) becomes less pronounced.

Accordingly, the product quality improves.

It should be also noted that the present method results in reduced production costs of silicon carbide articles through recycling of the material unsuitable for faceting.

## Claims

1. A method of simultaneous production of a plurality of precious stones from synthetic silicon carbidemoissanite, the method comprising growing simultaneously a plurality of moissanite crystal blanks in a honeycomb mold of molding graphite, separating the blanks into individual crystals, and faceting comprising three stages: rough cutting, grinding and polishing the crystals, wherein prior to faceting, the blanks are glued onto a mandrel with their one side and then--with the reverse side thereof, and polishing moissanite is carried out on a ceramic wheel rotating at a rate of 200 to 300 rpm using diamond powder spray with a grain size of 0.125-0.45 µm to ensure that the depth of scratch marks be less than the length of a light wave in the visible part of the spectrum, and wherein the cut and cleaved edges and defective blanks unsuitable for faceting are pulverized and returned to the stage of growing.

2. The method as claimed in claim 1, wherein a grinding paste with a grain size of 0.25 µm is used for grinding.
